# EUROPEAN PATENT APPLICATION

(11) **EP 4 589 384 A1**
(43) Date of publication of application: **23.07.2025**
(21) Application number: 23864986.7
(22) Date of filing: 22.05.2023
(51) Int. Cl.: G03F 7/20, G02B 26/08

(54) **OPTICAL DEVICE, EXPOSURE DEVICE, AND EXPOSURE METHOD**

(30) Priority: 16.09.2022 JP 2022148213
(71) Applicant: SCREEN Holdings Co., Ltd., Kyoto-shi, Kyoto 602-8585 (JP)
(72) Inventor: NISHIMURA, Tatsuhiko, Kyoto-shi, Kyoto 602-8585 (JP)
(74) Representative: Goddar, Heinz J.
(86) International application number: PCT/JP2023/018947
(87) International publication number: WO 2024/057622

(57) **Abstract**

This invention relates to an optical apparatus for shifting a course of light and an exposure apparatus and an exposure method using it, and is intended to adjust the amount of shift while suppressing an increase in the astigmatic difference even with a simple and compact configuration. The optical apparatus according to the invention includes a shift optical element which is a plane parallel plate having a one-side surface on which the input light is incident and an other-side surface from which the output light is emitted, which are surfaces parallel to each other, a correction optical element which is arranged on the optical path of the input light or the optical path of the output light and corrects an astigmatic difference appearing in the output light, and a driving part which rotates the shift optical element to change a shift amount and displaces the correction optical element in conjunction with the shift optical element.

## Description

### [Technical Field]

This invention relates to an optical apparatus which is applicable to a technique for exposing a substrate such as a semiconductor substrate, a semiconductor package substrate, a printed circuit board, a glass substrate, or the like to draw a pattern on the substrate.

### [Background]

There is an exemplary technique for forming a pattern such as a wiring pattern or the like on any one of various substrates such as a semiconductor substrate, a semiconductor package substrate, a printed circuit board, a glass substrate, and the like, where a light beam modulated in accordance with drawing data is caused to be incident on a photosensitive layer formed on a surface of a substrate, to thereby expose the photosensitive layer. In this type of technique, in order to perform drawing at an appropriate position while adapting distortion, deformation, or the like of a substrate, a means of shifting an incident position of the light beam with respect to the substrate is provided on an optical path.

In the technique disclosed in PTL 1, for example, a pair of wedge prisms placed opposite in reverse directions to each other is arranged on an optical path. Then, by changing a distance between the wedge prisms, achieved is a position shift of an image to be formed on an image surface with a light beam passing through the prisms. **In** this technique, an incident angle of light on the prism is set so that an astigmatic difference can become almost zero, when the distance between the prisms is a reference value. For a problem that the astigmatic difference increases as the distance between the prisms is changed at that time, proposed is a solution in which the incident angle of light should be changed by rotating the pair of wedge prisms.

### [Citation List]

### [Patent Literature]

PTL 1: JP 2009-244446A

### [Summary]

### [Technical Problem]

In the above-described conventional technique, in order to change the amount of shift without increasing the astigmatic difference, the distance between the prisms is increased or decreased in an optical axis direction and the pair of prisms is rotated in accordance with the change. For this reason, it is necessary to ensure a space for such a movement in advance, and further a total length of the optical path increases. **In a** combination with a reduction projection system, especially, in order to obtain a predetermined shift amount, the prisms need to be moved significantly longer than the above movement. From this fact, in terms of downsizing of the apparatus, there is still room for improvement in the above-described conventional technique.

Further, in the above-described conventional technique, from principle of using the prisms, by increasing or decreasing the shift amount with a state where the optical path has been shifted in advance to some degree, as a starting point, apparently, shift can be performed in both directions from a state where the shift is zero. Thus, even in a state where correction of the optical path by the shift is not inherently needed, since there is a bend of the optical path by the prisms, there is also a problem that the optimal design of the whole optical system may become complicated, such as a case where the optical path has a wavelength dependence, or the like case.

### [Solution to Problem]

This invention is intended to solve the above-described problems, and it is an object of this invention to provide, in a technique for shifting a course of light, a technique for adjusting the amount of shift while suppressing an increase in the astigmatic difference even with a simple and compact configuration.

One aspect of the present invention is intended for an optical apparatus for shifting an optical path of input light in a shift direction orthogonal to an incident direction thereof and outputting output light along an optical path which is in parallel to and is not the same as the optical path of the input light, and the optical apparatus includes a shift optical element which is a plane parallel plate having a one-side surface on which the input light is incident and the other-side surface from which the output light is emitted, which are surfaces parallel to each other, a correction optical element arranged on the optical path of the input light or the optical path of the output light, for correcting an astigmatic difference appearing in the output light, and a driving part for rotating the shift optical element to change a shift amount and displacing the correction optical element in conjunction with the shift optical element.

In this invention having such a configuration, the plane parallel plate as the shift optical element is arranged on the optical path so that light can pass through from the one-side surface to the other-side surface which are parallel to each other. When the plane parallel plate is arranged perpendicular to the optical path, the shift of the optical path does not occur. On the other hand, when the plane parallel plate is rotated about one rotation axis to be tilted with respect to the optical path, the optical path is shifted in a direction perpendicular to the rotation axis. At that time, since an optical path length is changed depending on an angle of the rotation, i.e., the magnitude of the tilt, an optical path length difference is caused between in a direction parallel to the shift direction and in another direction perpendicular thereto, and this causes an astigmatic difference.

Then, in this invention, the correction optical element is provided on the optical path and further displaced in conjunction with the shift optical element. Since the size of the astigmatic difference is changed in accordance with the rotation amount of the shift optical element, by linking the correction optical element with the shift optical element, it becomes possible to suppress an increase in the astigmatic difference even when the shift amount is changed.

As to the plane parallel plate, only by rotating the plane parallel plate, shift of the optical path can be achieved. Further, the displacement amount of the correction optical element for correcting the astigmatic difference does not become very large. Furthermore, since the optical path is not changed when the shift is zero, an optical design becomes easier as compared with the case of using prisms. Thus, according to the present invention, it becomes possible to adjust the shift amount while suppressing an increase in the astigmatic difference with a simple and compact configuration.

Further, another aspect of the present invention is intended for an exposure apparatus including a substrate holder for holding a substrate, an exposure part including the optical apparatus having the above-described configuration, for causing the outgoing light to be incident on a surface of the substrate, to thereby expose the substrate, and a relative moving part for relatively moving the exposure part and the substrate holder.

Furthermore, still another aspect of the present invention is intended for an exposure method to expose a substrate by causing modulated light to be incident on the substrate, and in the exposure method, an optical apparatus for shifting the light in a predetermined shift direction orthogonal to a traveling direction of the light is interposed in an optical path of the light, the substrate is moved relative to an incident position of the light emitted from the optical apparatus, and the light is caused to be incident on the substrate while adjusting a shift amount of the light, which is made by the optical apparatus. The optical apparatus includes a shift optical element which is a plane parallel plate having a one-side surface on which input light is incident and an other-side surface from which the output light is emitted, which are surfaces parallel to each other, and a correction optical element arranged on the optical path of the input light or the optical path of the output light, for correcting an astigmatic difference appearing in the output light, and rotates the shift optical element and displaces the correction optical element in conjunction with the shift optical element, to thereby adjust the shift amount.

In these aspects of the present invention, the optical apparatus shifts light, and it is thereby possible to adjust a position of the light to be incident on a substrate. In a case where the position accuracy in the arrangement of the substrates is low and there arises a deviation in an incident position of the light, for example, it is possible to correct the incident position on the substrate by shifting the light. In such an application, the optical apparatus of the present invention performs a function of adjusting a position of an image to be formed on the substrate by light irradiation. It thereby becomes possible to expose a desired position on the substrate. Further, since the optical apparatus to be used can be downsized, downsizing of the exposure apparatus including the optical apparatus can be achieved with the total length of the optical path reduced.

### [Advantageous Effects of Invention]

As described above, in the present invention, the plane parallel plate is used as the shift optical element for shifting light, and the astigmatic difference which is thereby caused can be canceled by linking the shift optical element with the correction optical element. For this reason, with a simple and compact configuration, it is possible to adjust the shift amount while suppressing an increase in the astigmatic difference.

The above and further objects and novel features of the invention will more fully appear from the following detailed description when the same is read in connection with the accompanying drawing. It is to be expressly understood, however, that the drawing is for purpose of illustration only and is not intended as a definition of the limits of the invention.

### [Brief Description of Drawings]

[FIG. 1] FIG. 1 is a view showing a first configuration example of an exposure apparatus including an optical apparatus in accordance with the present invention;
[FIG. 2] FIG. 2 is a view showing a second configuration example of the exposure apparatus including the optical apparatus in accordance with the present invention;
[FIG. 3A] FIG. 3A is a view showing a first embodiment of an image position adjusting apparatus;
[FIG. 3B] FIG. 3B is a view showing the first embodiment of the image position adjusting apparatus;
[FIG. 3C] FIG. 3C is a view showing the first embodiment of the image position adjusting apparatus;
[FIG. 4] FIG. 4 is a view showing an apparatus configuration for measuring a relation among a shift amount, a rotation angle, and an astigmatic difference;
[FIG. 5] FIG. 5 is a flowchart showing a process for performing a shift amount adjustment;
[FIG. 6] FIG. 6 is a flowchart showing an exposure operation;
[FIG. 7] FIG. 7 is a view showing a variation of the exposure apparatus shown in FIG. 1;
[FIG. 8A] FIG. 8A is a view showing a second embodiment of the image position adjusting apparatus;
[FIG. 8B] FIG. 8B is a view showing the second embodiment of the image position adjusting apparatus;
[FIG. 8C] FIG. 8C is a view showing the second embodiment of the image position adjusting apparatus;
[FIG. 9A] FIG. 9A is a view showing a third embodiment of the image position adjusting apparatus;
[FIG. 9B] FIG. 9B is a view showing the third embodiment of the image position adjusting apparatus; and
[FIG. 9C] FIG. 9C is a view showing the third embodiment of the image position adjusting apparatus.

### [Description of Embodiments]

Hereinafter, specific aspects of an optical apparatus in accordance with the present invention will be described by showing some embodiments. Herein, embodiments of a case where the optical apparatus in accordance with the present invention is applied to an exposure apparatus for exposing a substrate with a modulated light beam, to thereby perform drawing will be described. This exposure apparatus irradiates a substrate on which a layer of photosensitive material such as a resist or the like is formed, with laser light of a predetermined pattern, to thereby draw the pattern on the photosensitive material. As the substrate to be exposed, various substrates such as a printed circuit board, a semiconductor package substrate, a glass substrate for any one of various displays, a semiconductor substrate, and the like are applicable.

First, two configuration examples of the exposure apparatus to which the optical apparatus in accordance with the present invention is applicable will be described. After that, details of the optical apparatus to be applied to these exposure apparatuses will be described.

### <Exposure Apparatus of The First Configuration Example>

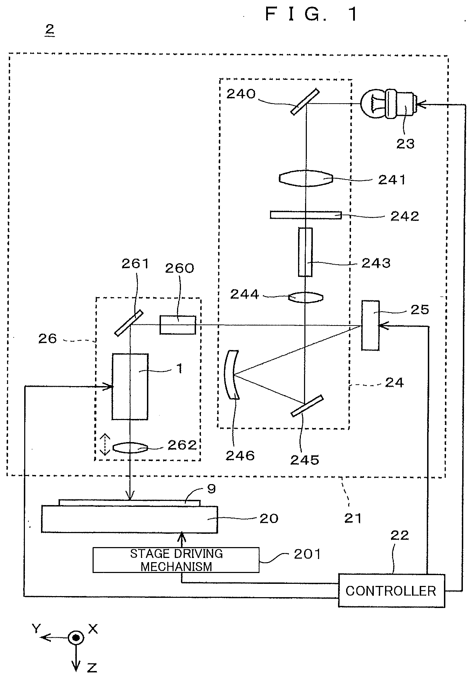

FIG. 1 is a view schematically showing a first configuration example of the exposure apparatus including the optical apparatus in accordance with the present invention. A basic configuration of this exposure apparatus 2 is the same as that disclosed in PTL 1 as an "optical apparatus 2". Then, description on the principle, the basic configuration, and the like which can be understood by reference to PTL 1 will be omitted, and herein an outline of an apparatus configuration will be simply described by using common reference signs as best as possible.

For the following description, an XYZ rectangular coordinate system is defined as shown in FIG. 1. FIG. 1 is a view showing a side view of the exposure apparatus 2, assuming that a direction which is horizontal and perpendicular to the paper of FIG. 1 is an X direction and another direction orthogonal to the X direction, which is horizontal and along the paper of FIG. 1, is a Y direction. Further, a vertical downward direction is assumed to be a Z direction.

The exposure apparatus 2 includes a movable stage 20, an exposure head 21, and a controller 22. The movable stage 20 holds a substrate 9 to be exposed in a horizontal posture. The exposure head 21 causes a modulated light beam to be incident on the substrate 9, to thereby draw a fine pattern on the substrate 9. The controller 22 executes a control program prepared in advance to control constituent elements of the apparatus, to thereby achieve a predetermined operation.

A stage driving mechanism 201 is coupled to the movable stage 20. The stage driving mechanism 201 includes a main scan driving mechanism for moving the movable stage 20 in the Y direction, a subscan driving mechanism for moving the movable stage 20 in the X direction, and a lifting and lowering mechanism for moving the movable stage 20 in the Z direction. As a driving source of these mechanisms, for example, a linear motor can be used. Thus, the exposure apparatus 2 can cause an exposure beam emitted from the exposure head 21 to be incident on an arbitrary position of the substrate 9, to thereby perform drawing.

The exposure head 21 includes a light source 23, an illumination optical system 24, a spatial light modulator 25, and an imaging optical system 26. The light source 23 is, for example, a lamp for emitting light which is to become the exposure beam. The illumination optical system 24 guides the light emitted from the light source 23 to the spatial light modulator 25. The spatial light modulator 25 modulates the light guided by the illumination optical system 24 on the basis of predetermined drawing data to generate a modulated light beam.

The illumination optical system 24 includes optical elements such as a mirror 240, a lens 241, an optical filter 242, a rod integrator 243, a lens 244, mirrors 245 and 246, and the like. With actions of these optical elements, the light from the light source 23 is formed in a beam shape and is guided to the spatial light modulator 25 with a predetermined incident angle.

As the spatial light modulator 25, for example, a digital micromirror device (DMD), a diffraction grating spatial light modulator element, or the like can be used. The spatial light modulator 25 modulates the light beam which is incident thereon on the basis of the drawing data. By doing so, the light beam is modulated in accordance with the shape of a pattern to be drawn. The modulated light beam is incident on a surface of the substrate 9 through the imaging optical system 26.

The imaging optical system 26 includes optical elements such as a first imaging lens 260, a mirror 261, an image position adjusting apparatus 1, a second imaging lens 262, and the like, which constitute a reduction optical system. With actions of these optical elements, an optical image in accordance with the shape of the pattern to be drawn is formed on the surface of the substrate 9. Specifically, the modulated light beam forms a primary image (intermediate image) by the first imaging lens 260, and the primary image is formed by the second imaging lens 262 to be a final image on the surface of the substrate 9 which is an image surface.

Further, a focus driving mechanism (not shown) for moving the second imaging lens 262 in the Z direction is coupled to the imaging optical system 26. The controller 22 operates this focus driving mechanism, and the second imaging lens 262 thereby moves in directions to approach and go away from the substrate 9 as indicated by a dotted arrow. This, focus adjustment of the imaging optical system 26 is performed so that the light beam emitted from the second imaging lens 262 can converge on the surface of the substrate 9.

The image position adjusting apparatus 1 corresponds to one embodiment of the "optical apparatus" in accordance with the present invention and has a function of shifting the light to be incident thereon by an arbitrary distance in an X-axis direction. When the optical apparatus in accordance with the present invention is applied to the exposure apparatus 2, the optical apparatus has a function of shifting the position of an image formed on the image surface, and in this sense, the optical apparatus serves as the image position adjusting apparatus. In this embodiment, the image position adjusting apparatus 1 is arranged between the primary image and the second imaging lens 262. The configuration and operation thereof will be described later.

### <Exposure Apparatus of The Second Configuration Example>

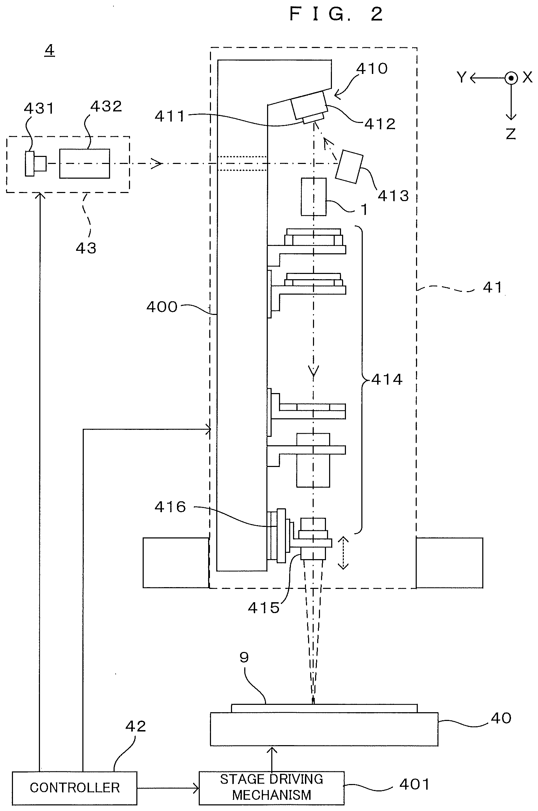

FIG. 2 is a view schematically showing a second configuration example of the exposure apparatus including the optical apparatus in accordance with the present invention. Also in FIG. 2, an XYZ rectangular coordinate system is defined according to FIG. 1. Specifically, FIG. 2 is a view showing a side view of the exposure apparatus 4, assuming that a direction which is horizontal and perpendicular to the paper of FIG. 2 is an X direction and another direction orthogonal to the X direction, which is horizontal and along the paper of FIG. 2, is a Y direction. Further, a vertical downward direction is assumed to be a Z direction.

As shown in FIG. 2, the exposure apparatus 4 includes a movable stage 40, a controller 42 and a light source unit 43. The movable stage 40 holds a substrate 9 to be exposed in a horizontal posture and is moved in X direction, Y direction and Z direction by a stage driving mechanism 401. The exposure head 41 causes a modulated light beam to be incident on the substrate 9, to thereby draw a fine pattern on the substrate 9. The controller 22 executes a control program prepared in advance to control constituent elements of the apparatus, to thereby achieve a predetermined operation.

The light source unit 43 has a laser diode 431, for example, as a laser light source and a illumination optical system 432 including a collimate lens for shaping the outgoing light thereof into parallel light, and causes a laser light beam functioning as an exposure beam to be incident on the exposure head 41.

A spatial light modulator 410 having a diffractive optical element 411 is disposed in the exposure head 41. Specifically, the spatial light modulator 410, which is attached to an upper portion of a supporting column 400 elongating in up-and-down direction (Z direction) in the exposure head 41, is supported by the supporting column 400 via a movable stage 412 in a state that a reflective surface of the diffractive optical element 411 faces down.

In the exposure head 41, the diffractive optical element 411 is arranged so that a normal line of the reflective surface is tilted with respect to an optical axis of an incident light beam. A light emitted from the light source unit 43 and indicated by a one-dot chain line is incident upon a mirror 413 through an opening disposed to the supporting column 400 and irradiates the diffractive optical element 411 after being reflected by the mirror 413. Then, the incident laser light beam to the diffractive optical element 411 is modulated by switching each channel state of the diffractive optical element 411 based on the exposure data by the controller 42.

The laser light reflected as 0th order diffracted light by the diffractive optical element 411 is incident to a lens in the imaging optical system 414. On the other hand, the laser light reflected as diffraction light of 1st order or higher by the diffractive optical element 411 is not incident to a lens in the imaging optical system 414. Specifically, only 0th order diffracted light by the diffractive optical element 411 is basically is incident to the imaging optical system 414.

The light passed through the lens of the imaging optical system 414 is converged by a focusing lens 415 and is lead onto the substrate 9 in a predetermined magnification as the exposure beam. The imaging optical system 414 constitutes a reduction optical system. The focusing lens 415 is attached to a focus driving mechanism 416. The focus driving mechanism 416 raises and lowers the focusing lens 415 in vertical direction (Z-axis direction) in response to the control command from the controller 42. By doing so, a convergence position of the exposure light emitted from the focusing lens 415 is adjusted on the upper surface of the substrate 9.

Thus, the light beam is modulated in accordance with the shape of a pattern to be drawn. The modulated light beam is incident on the surface of the substrate 9 through the imaging optical system 414, thereby a predetermined pattern is drawn on the surface of the substrate 9.

On an optical path from the diffractive optical element 411 toward the imaging optical system 414, the image position adjusting apparatus 1 is disposed. The configuration and function of the image position adjusting apparatus 1 are the same as those of the image position adjusting apparatus 1 provided in the exposure apparatus 2 of the first configuration example.

### <The First Embodiment of Image Position Adjusting Apparatus>

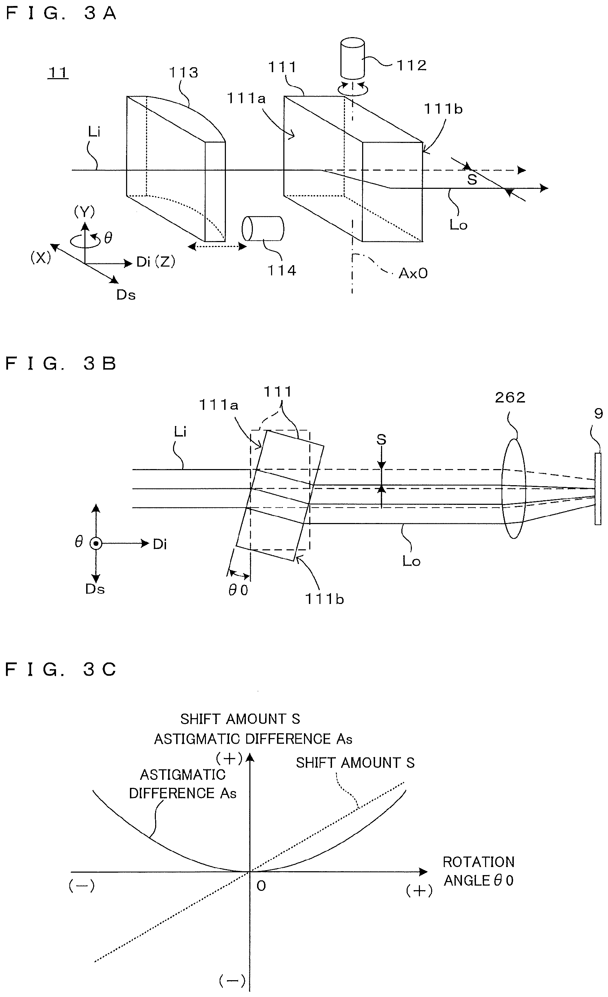

FIGs. 3A to 3C are views each showing the first embodiment of the image position adjusting apparatus. More specifically, FIG. 3A is a view showing a schematic configuration of the first embodiment 11 of the image position adjusting apparatus 1, and FIG. 3B is a view schematically showing an action thereof. FIG. 3C is a view showing a relation among a rotation angle of a plane parallel plate, a shift amount, and an astigmatic difference. Note that, though description will be made by exemplarily showing the configuration shown in FIG. 1 as the exposure apparatus incorporating the image position adjusting apparatus 1 hereinafter, the basic concept even in the combination with the configuration shown in FIG. 2 is the same.

First, with reference to FIG. 3A, a configuration of the image position adjusting apparatus 11 of this embodiment will be described. The image position adjusting apparatus 11 includes a shift optical element 111 which is a subject for shifting an optical path of the light beam and a correction optical element 113 for correcting an astigmatic difference. The shift optical element 111 is a plane parallel plate (also referred to as a plane parallel substrate) having an one-side main surface 111a serving as a light incident surface of input light Li and the other-side main surface 111b serving as a light outgoing surface, which are parallel to each other.

The shift optical element 111 is rotatable about a rotation axis Ax0 parallel to both these main surfaces 111a and 111b. Specifically, the shift optical element 111 is supported rotatably about the rotation axis Ax0 by a not-shown appropriate support mechanism and coupled to a rotary motor 112. The rotary motor 112 operates in response to a control command from the controller 22 and rotates the shift optical element 111 about the rotation axis Ax0. As a result, the input light Li is shifted in an incident direction thereof and a direction perpendicular to the rotation axis Ax0.

Herein, for the following description, introduced is a more universal coordinate axis which is unaffected by the posture of the image position adjusting apparatus inside the exposure apparatus or the bend of the optical path. That is, the incident direction of the input light Li is represented by the reference sign Di and the shift direction of the light beam is represented by the reference sign Ds. Further, an axis parallel to the rotation axis Ax0 is represented by the reference sign θ. In other words, the rotary motor 112 rotates the shift optical element 111 about the θ axis. Considering this in association with the apparatuses shown in FIGs. 1 and 2, it can be thought that the incident direction Di corresponds to the Z direction. Furthermore, for example, it can be thought that the shift direction Ds is the X direction and the θ axis is a Y axis.

In a state where the main surfaces 111a and 111b of the shift optical element 111 are perpendicular to the incident direction Di as indicated by a broken line in FIG. 3B, as indicated by a broken-line arrow in this figure, the input light Li entering the light incident surface 111a goes straight inside the shift optical element 111 and is outputted from the light outgoing surface 111b. Output light Lo forms an image on the surface of the substrate 9 through the second imaging lens 262. At that time, an image position is not shifted.

On the other hand, in a state where the shift optical element 111 is tilted about the θ axis by an angle θ0 as indicated by a solid line in FIG. 3B, there arises a change of the optical path due to refraction at each of the light incidence on the shift optical element 111 and the light outgoing from the shift optical element 111. The output light Lo is shifted by the size S along the shift direction Ds with respect to the course of the input light Li and emitted in a direction parallel to the input light Li. Hereinafter, the size S will be referred to as a "shift amount". The shift amount S is changed in accordance with the rotation amount θ0 of the shift optical element 111. As indicated by a dotted line in FIG. 3C, the shift amount S is changed linearly with respect to the angle θ0.

The image that thus shifted output light Lo forms on the surface of the substrate 9 through the second imaging lens 262 is also shifted in the X direction on the substrate 9. By doing so, the shift of the image position on the substrate is achieved.

The shift optical element 111 shifts the input light Li in the shift direction Ds perpendicular to the incident direction Di and the θ axis but causes no change in a direction along the θ axis. There appears an astigmatic difference in the output light Lo due to such anisotropy. For this reason, when the light beam is finally converged on the surface of the substrate 9, there arises a difference in the focusing position on the image surface between in the X direction and in the Y direction. This causes a deterioration in the drawing quality.

In order to solve this deterioration, the correction optical element 113 is provided in the image position adjusting apparatus 11. The correction optical element 113 is an optical element having power in the shift direction Ds and no power in the θ-axis direction, and is, for example, a cylindrical lens. Note that, the requirement for the correction optical element 113 is that the power in the shift direction Ds and that in the θ-axis direction are different from each other, and having no power in the θ-axis direction is not an essential requirement therefor.

By arranging the correction optical element 113 having different powers in the shift direction Ds and in the θ-axis direction on the optical path and correcting an optical path length difference, it is possible to cancel the difference in the focusing position on the surface of the substrate 9 between in the X direction and in the Y direction. In other words, it is possible to avoid the deterioration in the drawing quality due to the astigmatic difference.

From the knowledge of the inventor of the present application, as to the image shift by using the plane parallel plate, as indicated by a solid line in FIG. 3C, in a certain extent of the angle θ0 centering on zero, it is possible to approximately represent the size of the astigmatic difference As with respect to the angle θ0 by using a quadratic curve. Thus, since the size of the astigmatic difference As is changed depending on the angle θ0, it is necessary to change the amount of correction by the correction optical element 113 in accordance with the angle θ0.

This can be handled by moving the correction optical element 113 along the incident direction Di and changing the focusing position in the shift direction Ds (the X direction in the image surface). In order to make it possible, as shown in FIG. 3A, a driving motor 114 is coupled to the correction optical element 113. The driving motor 114 operates in response to the control command from the controller 22 and moves the correction optical element 113 in the direction Di as indicated by a dotted arrow.

When the rotation angle θ0 of the shift optical element 111 is changed in order to change the shift amount S, the controller 22 controls the rotary motor 112 and the driving motor 114 to change the position of the correction optical element 113 along the direction Di in conjunction with the change of the rotation angle θ0.

As described later, in the actual exposure operation, the necessary shift amount S is determined on the basis of distortion and warp of the substrate 9, variation in the placement position on the movable stage 20, or the like. Therefore, in accordance with the determined shift amount S, the rotation angle θ0 of the shift optical element 111 and the movement amount (hereinafter, represented by the reference sign M) of the correction optical element 113 have only to be immediately derived. Then, it becomes possible to satisfactorily perform drawing without being affected by such variations. This can be achieved, for example, by the following method.

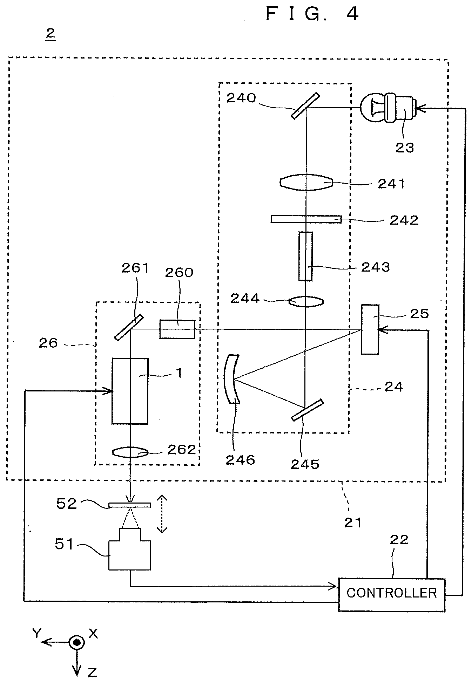

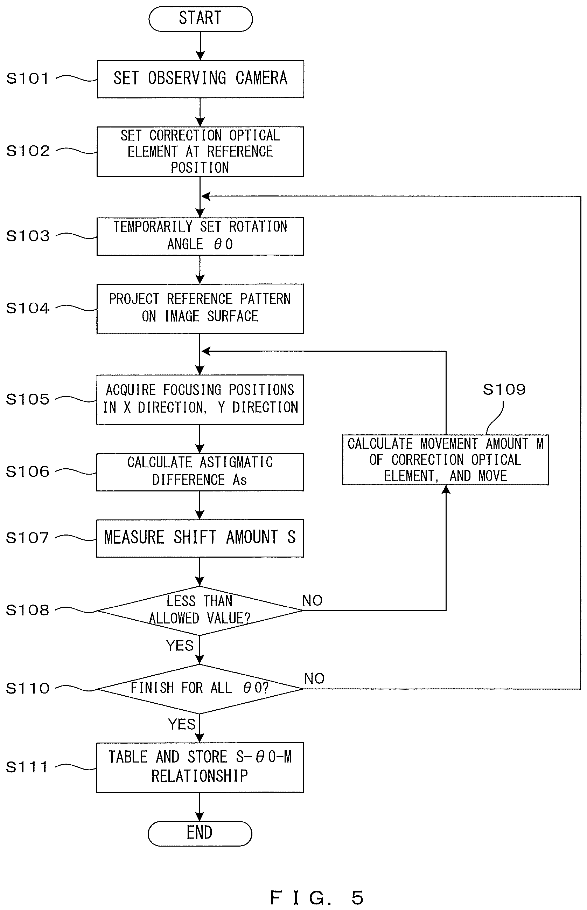

FIG. 4 is a view showing an apparatus configuration for measuring a relation among the shift amount, the rotation angle, and the astigmatic difference. Further, FIG. 5 is a flowchart showing a process for performing this adjustment. As shown in FIG. 4, instead of the substrate 9, a dummy substrate 52 is arranged at a position which corresponds to the image surface and an image projected on the dummy substrate 52 is captured by using an observing camera 51. By doing so, it is possible to detect a position of the image formed on the substrate 9. Though the observing camera 51 and the dummy substrate 52 may be provided for this purpose, these may be provided in advance for the purpose of, for example, calibration or the like of an automatic focusing mechanism in the exposure head.

In order to be positioned at a position immediately below the movable stage 20 selectively with the exposure head 21, the observing camera 51 and the dummy substrate 52 are required to move in a horizontal direction. Further, for the search of the focusing position described later, the observing camera 51 and the dummy substrate 52 are required to move in the Z direction. The observing camera 51 and the dummy substrate 52 can be attached to, for example, a side portion of the movable stage 20 provided with a moving mechanism used for movement in these directions.

A specific process is as follows. First, instead of the movable stage 20, the dummy substrate 52 and the observing camera 51 are arranged at a position which corresponds to the image surface of the exposure beam (Step S101). Further, the correction optical element 113 is temporarily set at an appropriate reference position (Step S102). Hereinafter, while the angle θ0 is sequentially changed, the shift amount S and movement amount M in accordance therewith are acquired.

Specifically, first, the rotation angle θ0 of the shift optical element 111 is temporarily set to an appropriate value (Step S103). In a first trial, for example, it can be set that the angle θ0 is zero, in other words, the input light Li is incident on the shift optical element 111 perpendicularly.

In this state, a predetermined reference pattern is projected to a surface of the dummy substrate 52 at the image surface by the exposure head 21 (Step S104). This reference pattern is used for individually measuring the respective focusing positions in the X direction and the Y direction, and a combination of a line in the X direction and a line in the Y direction, for example, can be used. Projection of the reference pattern may be performed by modulating the exposure beam by the spatial light modulator 25, and further may be performed by arranging a mask for adjustment on the optical path.

Thus, by using the reference pattern projected on the surface of the dummy substrate 52, the shift amount S and the astigmatic difference As are obtained. Specifically, the observing camera 51 captures an image of the reference pattern and image data is given to the controller 22. While moving integrally the observing camera 51 and the dummy substrate 52 in the Z direction, the controller 22 acquires a position at which the reference pattern in the X direction is projected to the image surface most vividly, i.e., focused on the image surface and a position at which the reference pattern in the Y direction is focused on the image surface are acquired (Step S105). Then, a difference therebetween is calculated to be the astigmatic difference As (Step S106).

Further, a position in the X direction of the reference pattern in the X direction is detected and the shift amount S at the angle θ0 is measured (Step S107). With a position of the reference pattern at the time when the angle θ0 is zero as an origin point, when the angle θ0 is not zero, the displacement amount from the origin point can be obtained as the shift amount S.

When the obtained astigmatic difference As exceeds a predetermined allowed value ("NO" in Step S108), the movement amount M of the correction optical element 113 for reducing the astigmatic difference As is obtained on the basis of the size and sign thereof, and the driving motor 114 is operated in accordance with the result, to thereby adjust the position of the correction optical element 113 (Step S109). As the movement amount M of the correction optical element 113, for example, a value obtained by dividing the value of the astigmatic difference calculated in the image surface by the square of the magnification of the optical system between the image position adjusting apparatus 1 and the image surface can be used.

Then, evaluation of the astigmatic difference or the like in Steps S105 to S109 is performed again. By repeating this until the condition for "YES" in Step S108 is satisfied, the position of the correction optical element 113 can be led to an optimal position for minimizing the astigmatic difference (ideally, to zero). Thus, the correspondence among a rotation angle θ0, the corresponding shift amount S, and the movement amount M of the correction optical element 113 is obtained. These values are temporarily stored into a memory device inside the controller 22.

The operations in Steps S103 to S109 are repeated while the value of the rotation angle θ0 is changed variously until the process is ended on all the necessary angles θ0 (Step S110). By performing this, as to various values of the angle θ0, a relation among the shift amount S obtained then and the movement amount M of the correction optical element 113 needed for correcting the astigmatic difference As is obtained.

Note that, the shift amount S does not necessarily need to be measured every time in a process loop of Steps S105 to S109. At the point in time when optimization of the movement amount M is ended, for example, the shift amount S may be obtained from the position of the reference pattern at that time.

These results are tabled and stored into the memory device of the controller 22 (Step S111). As described above, in the exposure operation, the necessary shift amount S is determined at first. In accordance with the determined shift amount S, the rotation angle θ0 of the shift optical element 111 and the movement amount M of the correction optical element 113 are selected. Therefore, it is desirable that, for each of various shift amounts S, the rotation angle θ0 of the shift optical element 111 and the movement amount M of the correction optical element 113 needed to achieve the shift amount S are associated therewith and tabled.

It is enough to perform this adjustment process at timings such as at the start-up of the apparatus, during the regular maintenance, at the time when duration of the operation of the apparatus or the number of processed substrates reaches a predetermined value, and the like. Further, in a case where the apparatus is placed in a stable environment with less temperature change, for example, the adjustment has only to be performed during installation in the most extreme sense. In any case, the frequency of execution is not so high, and particularly, the adjustment does not need to be performed during execution of the exposure operation described next.

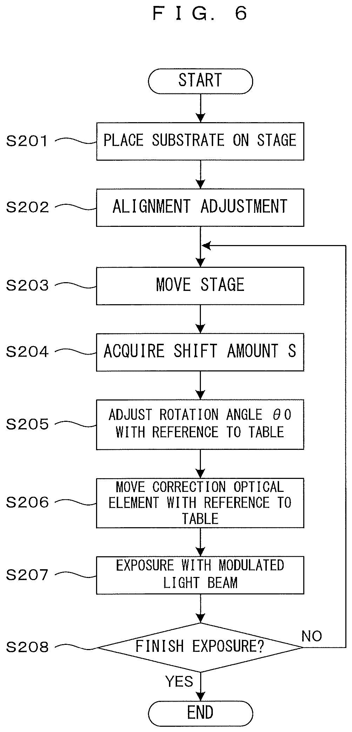

FIG. 6 is a flowchart showing the exposure operation. In the exposure operation of exposing the substrate 9 to perform pattern drawing, first, the substrate 9 to be exposed is loaded into the apparatus and placed on the movable stage 20 (Step S201). Next, performed is alignment adjustment in which a positional relation between the substrate 9 on the movable stage 20 and the exposure head 21 is grasped and position adjustment is performed as necessary (Step S202). Description on the alignment adjustment will be omitted since a well-known technique is applicable thereto.

Then, the movable stage 20 is moved to and positioned at a predetermined exposure position (Step S203), and from a detection result of positional deviation of the substrate 9 grasped in the alignment adjustment, the shift amount S of the image needed to handle the positional deviation is acquired (Step S204). When the shift amount S is thus determined, by reference to the prepared table as described above, the rotation angle θ0 of the shift optical element 111 needed to determine the shift amount S and the movement amount M of the correction optical element 113 needed to cancel the astigmatic difference As by correction can be obtained. The respective positions of the shift optical element 111 and the correction optical element 113 are adjusted on the basis of the rotation angle θ0 and the movement amount M (Steps S205 and S206).

In this state, the exposure beam modulated in accordance with the drawing data is emitted from the exposure head 21. Thus, the surface of the substrate 9 is exposed (Step S207), and a predetermined pattern is drawn. Until drawing on the substrate 9 is ended (Step S208), the operations in Steps S203 to S207 are continuously performed. The exposure operation on one substrate 9 is thereby ended.

As described above, in the image position adjusting apparatus 11 of the first embodiment provided in the exposure apparatus 2 or 4, the plane parallel plate is used as the shift optical element 111 for shifting the optical path of the light beam to be emitted onto the substrate 9. By rotating the plane parallel plate about the rotation axis Ax0 (θ axis) perpendicular to the shift direction Ds of the light beam, it is possible to shift the light beam by the predetermined shift amount S. As to the astigmatic difference As occurring at that time, by arranging the correction optical element 113 having power in the shift direction Ds on the optical path, the optical path length difference from that in the θ-axis direction is canceled. The correction optical element 113 is linked with the rotation of the shift optical element 111. By determining the movement amount M of the correction optical element 113 in accordance with the rotation angle θ0, it is possible to prevent the astigmatic difference from occurring even when the shift amount S is changed.

Since the shift optical element 111 only rotates within a predetermined angle range (e.g., about ±10 degrees), any large space to ensure the range of motion is not needed. Further, the size of the astigmatic difference As is about several µm at the most, and the movement amount M of the correction optical element 113 for correcting the astigmatic difference As is relatively small. For this reason, the extension of the optical path caused by providing a configuration for image position shift needs only the minimum length, and it is possible to avoid upsizing of the apparatus.

### <Variation of The First Embodiment>

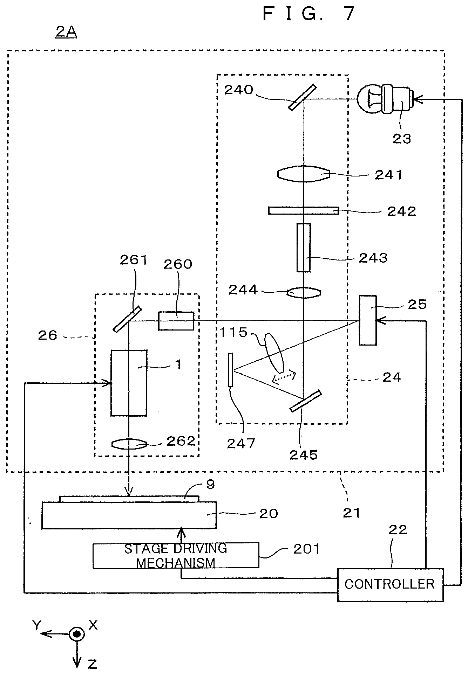

FIG. 7 is a view showing a variation of the exposure apparatus shown in FIG. 1. In an exposure apparatus 2A of this variation, the mirror 246 in the exposure apparatus 2 shown in FIG. 1 is replaced with a plane mirror 247 and further a lens 115 is provided as the correction optical element on the optical path between the plane mirror 247 and the spatial light modulator 25. Thus, the correction optical element does not need to be provided immediately before the shift optical element 111 and can be disposed at an appropriate position on the optical path.

Then, in this case, a correction optical element 115 also has a function as a focus lens for the spatial light modulator 25. The movement amount M of the correction optical element 115 for correcting the astigmatic difference As is relatively small and falls within, for example, a range of the depth of focus of the focus lens. For this reason, the focus lens can be used to correct the astigmatic difference without any effect on focus adjustment for the spatial light modulator 25. Thus, both the functions of the focus lens and the correction optical element can be achieved by one lens, and it thereby becomes possible to reduce the optical path length of the whole optical system and achieve downsizing of the apparatus.

### <The Second Embodiment>

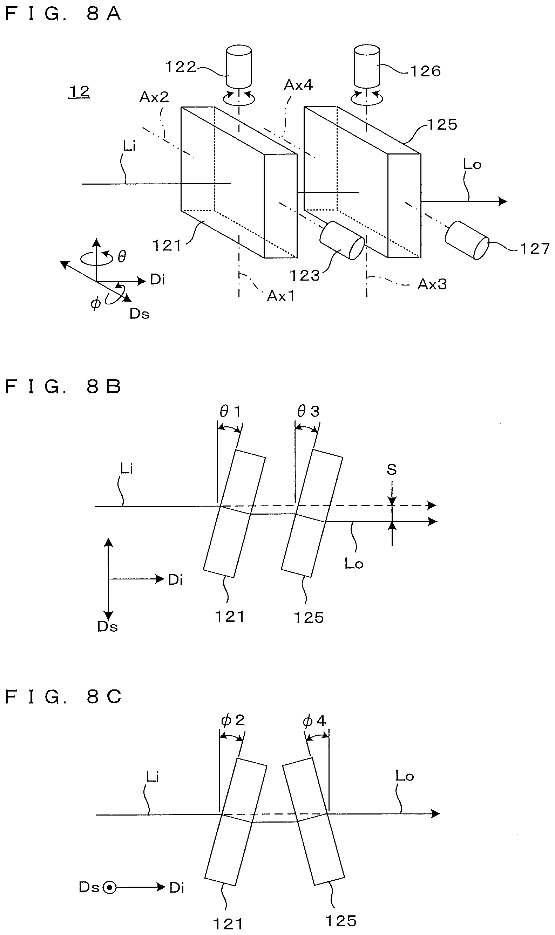

FIGs. 8A to 8C are views each showing the second embodiment of the image position adjusting apparatus. More specifically, FIG. 8A is a view showing a schematic configuration of the second embodiment of the image position adjusting apparatus 1, and FIGs. 8B and 8C are views each schematically showing an action thereof. As shown in FIG. 8A, an image position adjusting apparatus 12 which is the second embodiment of the image position adjusting apparatus 1 has two plane parallel plates 121 and 125 arranged along the optical path of the input light Li. It is desirable that these two plane parallel plates 121 and 125 have the same thickness, i.e., the same distance between the light incident surface and the light outgoing surface.

The first plane parallel plate (plane parallel substrate) 121 disposed on an upstream side in the optical path of the input light Li is rotatable about two rotation axes Ax1 and Ax2. Both the two rotation axes Ax1 and Ax2 are perpendicular to the incident direction Di and perpendicular to each other. Specifically, the first plane parallel plate 121 is supported rotatably about the two rotation axes Ax1 and Ax2 which are orthogonal to each other. As a support mechanism for the plane parallel plate 121, for achieving such rotation, for example, a well-known gimbal mechanism can be applied.

Two rotary motors 122 and 123 which operate in response to the control command from the controller 22 are coupled to the plane parallel plate 121 which is thus supported. The rotary motor 122 rotates the plane parallel plate 121 about the rotation axis Ax1. Further, the rotary motor 123 rotates the plane parallel plate 121 about the rotation axis Ax2. The rotation axis Ax1 is an axis parallel to the θ axis perpendicular to the shift direction Ds, and the rotation axis Ax2 is an axis parallel to the shift direction Ds. Herein, the axis parallel to the shift direction Ds is referred to as a φ axis.

Similarly, the second plane parallel plate 125 disposed on a downstream side of the first plane parallel plate 121 in the optical path of the input light Li is rotatable about two rotation axes Ax3 and Ax4 by two rotary motors 126 and 127 operating in response to the control command from the controller 22. Both the two rotation axes Ax3 and Ax4 are perpendicular to the incident direction Di and perpendicular to each other. The second plane parallel plate 125 is rotatable about the rotation axis Ax4. Herein, the rotation axis Ax3 is parallel to the rotation axis Ax1 and the rotation axis Ax4 is parallel to the rotation axis Ax2.

In response to the control command from the controller 22, the four rotary motors 122, 123, 126, and 127 are linked with one another. Specifically, the rotary motors 122 and 126 rotate the plane parallel plates 121 and 125 about the two rotation axes Ax1 and Ax3 parallel to the θ axis with the same angles θ1 and θ3 in the same direction, respectively. On the other hand, the rotary motors 123 and 127 rotate the plane parallel plates 121 and 125 about the two rotation axes Ax2 and Ax4 parallel to the shift direction Ds (φ axis) with the same angles in the reverse directions, respectively.

As shown in FIG. 8B, when the two plane parallel plates 121 and 125 are rotated in the same direction, the plane parallel plates 121 and 125 shift the light in the same direction. Therefore, the final shift amount S is obtained by adding the respective shift amounts generated by the plane parallel plates 121 and 125 thereto.

On the other hand, as shown in FIG. 8C, when the two plane parallel plates 121 and 125 are rotated in the reverse directions, the plane parallel plates 121 and 125 shift the light in the reverse directions. In other words, the shifts of the light by the plane parallel plates 121 and 125 are caused in the directions to cancel each other. When the plane parallel plates 121 and 125 have the same thickness and the same size of the rotation angles φ2 and φ4, the shift amounts offset each other and the shift amount in the θ-axis direction becomes zero.

Thus, by rotating the two plane parallel plates 121 and 125 about the θ axis with the same angle in the same direction and about the φ axis with the same angle in the reverse directions, the following effect is produced. Specifically, the rotation about the θ axis can shift the light in the shift direction Ds orthogonal to the θ axis. On the other hand, the shifts by the rotation about the φ axis offset each other to become zero. Therefore, only in the desired shift direction Ds, the light can be shifted. The shift amount S can be obtained as the total of the shift amounts by the two plane parallel plates 121 and 125, and it is possible to adjust the shift amount S with these rotation angles θ1 and θ3.

When the rotation angles θ1 and θ3 about the θ axis and the rotation angles φ2 and φ4 about the φ axis have the same size, the changes in the optical path length caused when the light passes through the plane parallel plates 121 and 125 are the same between in the θ-axis direction and in the shift direction Ds. Therefore, no astigmatic difference occurs in this case. In other words, the two plane parallel plates 121 and 125 complementarily act and occurrence of the astigmatic difference is thereby suppressed.

Note that, it is assumed herein that the two plane parallel plates 121 and 125 have the same thickness and the rotation angles θ1, φ2, θ3, and φ4 have the same size. As to the rotation about the θ axis, since the total shift amount S is determined by simply adding the shifts of the light by the two plane parallel plates 121 and 125, insofar as the respective shift amounts are individually known, the plane parallel plates 121 and 125 may not have the same thickness and the rotation angles θ1 and θ3 may not have the same size. Also as to the rotation about the φ axis, insofar as the shift amounts each determined by the combination of the thickness and the rotation angle can offset each other, the plane parallel plates 121 and 125 may not have the same thickness and the rotation angles φ2 and φ4 may not have the same size.

Considering that the rotary motors 122, 123, 126, and 127 are caused to be linked with one another, however, when the plane parallel plates 121 and 125 have different thicknesses and the rotation angles θ1, φ2, θ3, and φ4 have different sizes, the mechanism and control to achieve that disadvantageously become complicated and there is no particular advantage.

As described above, when the two plane parallel plates 121 and 125 have the same thickness and the rotation angles θ1, φ2, θ3, and φ4 have the same size, the mechanism and control can become the simplest ones. Further, the two plane parallel plates 121 and 125 can be components having the same specification. These contribute to the operational stability and reduction in the cost of the apparatus. Note that, for the purpose other than the above, there may be an operation mode where all the rotation angles θ1, φ2, θ3, and φ4 do not have the same size.

In this embodiment, only with the rotations of the two plane parallel plates, the shift of the optical path is achieved and the astigmatic difference caused accordingly is suppressed. For this reason, it is not necessary to set the optical path length longer in order to perform the shift, and the optical system can thereby have a compact configuration. Further, in order to obtain the shift amount equal to that in the first embodiment when the rotation angle of each of the plane parallel plates is set to be almost equal thereto, for example, it is possible to reduce the thickness of the plane parallel plate to half of that in the first embodiment.

Thus, in the image position adjusting apparatus 12 of this embodiment, the two plane parallel plates 121 and 125 each serve as a shift optical element. Along with this, in terms that the astigmatic difference caused by one is canceled by the other, these plane parallel plates each serve as a correction optical element for each other.

An operation of the exposure apparatus 2 which has the image position adjusting apparatus 12 having such a configuration is as follows. First, the adjustment operation shown in FIG. 5 becomes easier. Specifically, in this embodiment, the rotation angles of the two plane parallel plates 121 and 125 about the φ axis have the same size in the reverse directions, and the astigmatic difference is thereby automatically corrected. Therefore, insofar as the rotation angles φ2, θ3, and φ4 are changed in conjunction with the angle θ1, only a relation between a set value of the rotation angle θ1 and the shift amount S which is thereby obtained has only to be acquired.

Then, in the exposure operation shown in FIG. 6, when the necessary shift amount S is determined, the rotation angle θ1 in accordance with the shift amount S can be acquired from the table and the angles φ2, θ3, and φ4 can be determined on the basis of the rotation angle θ1. By rotating the two plane parallel plates 121 and 125 on the basis of the determination, it is possible to perform the shift by the desired shift amount S and form an image with no astigmatic difference. Therefore, it can be handled by replacing "θ0" with "θ1" in Step S205 and omitting Step S206. The same applies to the third embodiment described next.

### <The Third Embodiment>

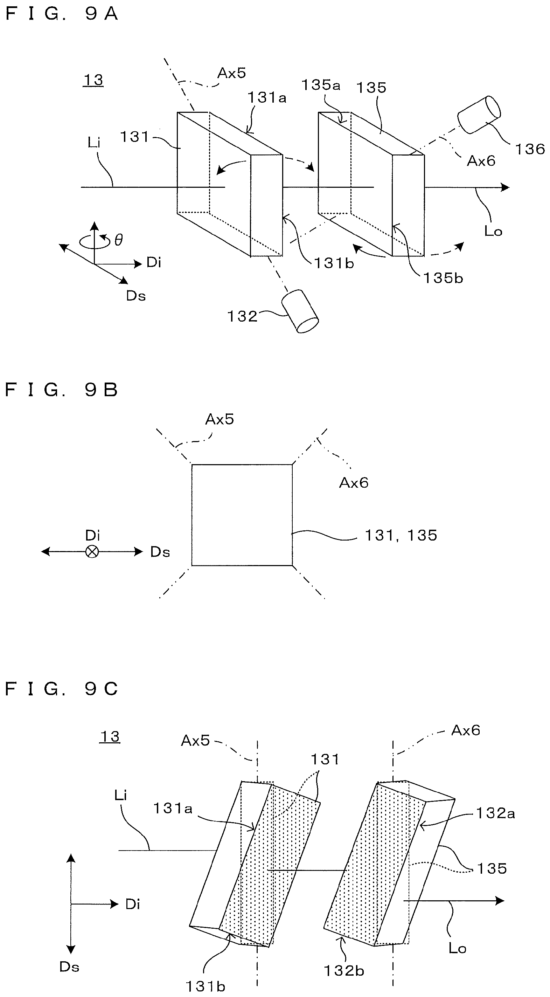

FIGs. 9A to 9C are views each showing the third embodiment of the image position adjusting apparatus. More specifically, FIG. 9A is a view showing a schematic configuration of the third embodiment of the image position adjusting apparatus 1, and FIG. 9B is a view showing a direction of a rotation axis in this embodiment. Further, FIG. 9C is a view schematically showing an action of an image position adjusting apparatus 13.

As shown in FIG. 9A, this image position adjusting apparatus 13 is common to the image position adjusting apparatus 12 of the second embodiment in that two plane parallel plates 131 and 135 having the same thickness are arranged on the optical path. As shown in this figure, like in the image position adjusting apparatus 12 of the second embodiment, when the two plane parallel plates 131 and 135 are arranged perpendicular to the optical path of the input light Li, no shift of the light occurs.

However, the setting of the rotation axis and the manner of the rotation of the plane parallel plates 131 and 135 which is accordingly determined are different from those in the second embodiment. Specifically, as indicated by a one-dot chain line in FIGs. 9A and 9C, a rotation axis Ax5 of the first plane parallel plate 131 is perpendicular to the incident direction Di of the light and has a tilt of 45 degrees with respect to the shift direction Ds. A rotary motor 132 is connected to the plane parallel plate 131. When the rotary motor 132 operates in response to the control command from the controller 22, the plane parallel plate 131 rotates about the rotation axis Ax5.

On the other hand, as indicated by a two-dot chain line in FIGs. 9A and 9C, a rotation axis Ax6 of the second plane parallel plate 135 is set to be perpendicular to the incident direction Di of the light and to have a tilt of 45 degrees with respect to the shift direction Ds in the reverse direction to the rotation axis Ax5. Therefore, the rotation axis Ax5 and the rotation axis Ax6 have a twisted positional relation in which the respective directions of these rotation axes are perpendicular to each other. A rotary motor 136 is connected to the plane parallel plate 135. When the rotary motor 136 operates in response to the control command from the controller 22, the plane parallel plate 135 rotates about the rotation axis Ax6.

The rotary motors 132 and 136 are linked with each other, and when these rotary motors operate, the two plane parallel plates 131 and 135 rotate as follows. Specifically, when the first plane parallel plate 131 rotates in a direction indicated by a solid-line arrow, the second plane parallel plate 135 accordingly rotates in a direction indicated by the solid-line arrow. Conversely to this, when the first plane parallel plate 131 rotates in a direction indicated by a broken-line arrow, the second plane parallel plate 135 accordingly rotates in a direction indicated by the broken-line arrow. The size of the rotation angle is controlled to be always the same.

FIG. 9C is a bird's-eye view from the θ-axis direction, showing a positional relation of the two plane parallel plates 131 and 135 which are rotated only by a predetermined angle. In FIG. 9C, for easy viewing of this figure, among the main surfaces of the two plane parallel plates 131 and 135, hatched are the surfaces facing each other in a state of FIG. 9A where the two plane parallel plates are disposed in parallel to each other.

When the two plane parallel plates 131 and 135 are linked with each other as described above, as shown in FIG. 9C, in the two plane parallel plates 131 and 135, sides 131a and 135a extending in the shift direction Ds in the state shown in FIG. 9A are tilted in the same direction. On the other hand, sides 131b and 135b extending in a direction perpendicular to the shift direction Ds in the state shown in FIG. 9A are tilted in the reverse directions to each other.

This relation is similar to the relation between the rotation about the θ axis and that about the φ axis in the image position adjusting apparatus 12 of the second embodiment. Specifically, also in this embodiment, the shifts of the light by the two plane parallel plates 131 and 135 occur in the same direction in the shift direction Ds, and on the other hand, the shifts offset each other in the direction perpendicular to the shift direction Ds. The size of the shift amount S in the shift direction Ds depends on the rotation angle of each of the plane parallel plates 131 and 135.

Specifically, in the image position adjusting apparatus 13 of this embodiment, the two plane parallel plates 131 and 135 each have a tilt of 45 degrees with respect to the shift direction Ds and rotate about the rotation axis Ax5 and the rotation axis Ax6, respectively, which are perpendicular to each other and have a twisted positional relation. With such a configuration, like in the image position adjusting apparatus 12 of the second embodiment, it is possible to shift the light by the desired shift amount S with respect to the desired shift direction Ds and moreover suppress occurrence of the astigmatic difference.

While the image position adjusting apparatus 12 of the second embodiment has the four rotation axes, the image position adjusting apparatus 13 of this embodiment can achieve the same function with the two rotation axes. Therefore, in terms of simplification and downsizing of the apparatus configuration, this third embodiment is more advantageous. Further, in terms of control, the third embodiment having less targets to be controlled is more advantageous. On the other hand, in terms that the rotation about the θ axis and that about the φ axis can be independently controlled, the second embodiment is more advantageous.

### <Miscellaneous>

As described above, in the above-described embodiments, the image position adjusting apparatus 1 (11 to 13) functions as an "optical apparatus" of the present invention. Further, the exposure apparatuses 2, 2A, and 4 each function as an "exposure apparatus" of the present invention. Furthermore, the movable stages 20 and 40 each function as a "substrate holder" of the present invention, the exposure head 24 and 41 each function as an "exposure part" of the present invention, and the stage driving mechanisms 201 and 401 each function as a "relative moving part" of the present invention. Further, the spatial light modulator 25 and the spatial light modulator 410 each function as a "light modulator" of the present invention.

Furthermore, in the first embodiment, the plane parallel plate 111 functions as a "shift optical element" of the present invention, and the correction optical element 113 which is a cylindrical lens functions as a "correction optical element" and a "lens" of the present invention. Further, the rotary motor 112 and the driving motor 114, as a unit, function as a "driving part" of the present invention.

Further, in the second embodiment, it can be seen that the plane parallel plate 121 corresponds to a "shift optical element" of the present invention, and the plane parallel plate 125 corresponds to a "correction optical element" and a "second plane parallel plate" of the present invention. These operations are complementary, however, and conversely to the above, it can be also seen that the plane parallel plate 125 corresponds to a "shift optical element" of the present invention, and the plane parallel plate 121 corresponds to a "correction optical element" and a "second plane parallel plate" of the present invention. Then, the rotary motors 122, 123, 126, and 127 each function as a "driving part" of the present invention. Further, the rotation axes Ax1 to Ax6 correspond to "first to sixth rotation axes".

Furthermore, in the third embodiment, it can be seen that the plane parallel plate 131 corresponds to a "shift optical element" of the present invention, and the plane parallel plate 135 corresponds to a "correction optical element" and a "second plane parallel plate" of the present invention, but also in this embodiment, these operations are complementary. Conversely to the above, it can be also seen that the plane parallel plate 135 corresponds to a "shift optical element" of the present invention, and the plane parallel plate 121 corresponds to a "correction optical element" and a "second plane parallel plate" of the present invention. Then, the rotary motors 136 and 137 each function as a "driving part" of the present invention.

Note that the invention is not limited to the above embodiments and various changes other than the aforementioned ones can be made without departing from the gist of the invention. **In** the above-described embodiments, for example, for principle explanation, each movable axis is driven by an independent motor (rotary motor and driving motor). As described earlier, however, in the embodiments, a plurality of motors in conjunction with one another effectively work. For this reason, there may be a configuration where a plurality of movable axes are coupled to one another by an appropriate power transmission mechanism and are driven by one power source. It is thereby possible to reduce the number of motors to be used. Furthermore, to the power source for driving each constituent element, any one of various power sources such as a linear motor, a ball-screw mechanism, an air cylinder, a solenoid mechanism, and the like, as well as the rotary motor, can be applied.

Further, in the above-described first embodiment, the correction optical element 113 is a single cylindrical lens. The correction optical element, however, may be constituted of, for example, a combination of a cylindrical lens whose axial direction is the X direction and another cylindrical lens whose axial direction is the Y direction, having a focal length different from that of the above cylindrical lens. Furthermore, the correction optical element may also have a function of any one of the lenses or the like provided in the illumination optical system or the imaging optical system. Further, as the correction optical element, for example, a concave lens, a convex mirror, or the like may be used. Furthermore, the outer shapes of the shift optical element and the correction optical element are also not limited to those shown in figures. For example, a plane parallel plate having a disk-like shape may be used.

Further, as to the arrangement position of the correction optical element, the correction optical element may be arranged at an appropriate position where the astigmatic difference caused by the operation of the shift optical element can be corrected, and the arrangement position is not limited to those in the above-described embodiments.

Furthermore, in the adjustment process of the above-described embodiments, the goal of the correction of the astigmatic difference by the correction optical element is not higher than a predetermined allowed value. The goal of the corrected astigmatic difference, however, may be zero, and naturally the most ideal state is a state where the astigmatic difference is zero and there is no variation.

Further, in the above-described embodiments, the optical apparatus in accordance with the present invention is applied to an exposure apparatus for exposing a substrate to perform pattern drawing. However, the target to which the optical apparatus of the present invention is applied is not limited to this. The optical apparatus of the present invention can be applied to, for example, a projection apparatus such as a projector.

Thus, as described above by taking the specific embodiments as examples, in the optical apparatus in accordance with the present invention, for example, the range of the rotation of the shift optical element by the driving part may be set to include a case where the one-side surface is perpendicular to the incident direction. In the case where a prism is used, the design of the optical system becomes complicated since a bend of the optical path occurs even when the shift amount is zero. In contrast to this, in the case where the plane parallel plate is used to shift the optical path, the shift amount becomes zero by causing the input light to be perpendicularly incident on the main surface thereof. Therefore, the optical system can be designed with the case where the shift amount is zero with no bend of the optical path, as a reference.

Further, for example, the correction optical element may be a lens having different powers in a direction along the shift direction and in a direction perpendicular to the shift direction. In this case, the driving part can move the correction optical element along the optical path in directions to approach and go away from the shift optical element. Since the focal length of such a lens is different between in the shift direction and in the direction perpendicular to the shift direction, this can be used for correcting the astigmatic difference. In this case, by adjusting the position of the correction optical element in accordance with the rotation angle of the plane parallel plate, it is possible to cancel the astigmatic difference with respect to an arbitrary shift amount.

Furthermore, for example, the correction optical element may be the second plane parallel plate which is different from the shift optical element. In this case, the driving part rotates the shift optical element about the first rotation axis perpendicular to the incident direction of the input light and the shift direction and about the second rotation axis perpendicular to the incident direction and the first rotation axis, respectively. Further, the driving part can rotate the correction optical element about the third rotation axis parallel to the first rotation axis and about the fourth rotation axis parallel to the second rotation axis, respectively, in conjunction with the shift optical element.

With such a configuration, it is possible to rotate the shift optical element and the correction optical element about two rotation axes perpendicular to each other, respectively. When the shift optical element and the correction optical element are rotated in the same direction, the respective shifts of the optical path are caused in the same direction. On the other hand, when the shift optical element and the correction optical element are rotated in the reverse directions, the respective shifts of the optical path are caused in the directions to offset each other. By using this fact, it is possible to obtain an arbitrary shift amount in one shift direction and cause no shift in a direction perpendicular to the above shift direction. Further, since the optical path lengths are changed in the same manner both in the directions, it becomes possible to prevent the astigmatic difference from occurring.

More specifically, for example, when the shift optical element and the correction optical element have the same thickness and the driving part rotates the shift optical element about the first rotation axis by a predetermined angle, the driving part rotates the correction optical element about third rotation axis by a predetermined angle and rotates the shift optical element in the same direction. Along with this, the driving part can rotate the shift optical element about the second rotation axis and rotate the correction optical element about the fourth rotation axis by a predetermined angle in the reverse directions to each other.

With such a configuration, between the two plane parallel plates, the shift amounts having the same size and the same direction can be obtained in the shift direction. Along with this, in the direction perpendicular to the shift direction, the shift amounts having the same size and reverse directions can be obtained. For this reason, it is possible to obtain only a shift along the shift direction. On the other hand, the amounts of change in the optical path length caused by interposing the plane parallel plate are always equal between in the shift direction and in the direction perpendicular to the shift direction. For this reason, the astigmatic difference due to the difference in the optical path length does not occur. More exactly, the respective astigmatic differences caused by the plane parallel plates cancel each other.

Further, as a configuration different from the above, for example, the correction optical element is the second plane parallel plate having the same thickness as that of the shift optical element, and the driving part can rotate the shift optical element about the fifth rotation axis which is perpendicular to the incident direction of the input light and has a tilt of 45 degrees with respect to the shift direction and rotate the correction optical element about the sixth rotation axis which is perpendicular to the incident direction of the input light and the fifth rotation axis in conjunction with the rotation of the shift optical element.

Though details are described above, with such a configuration, by rotating the two plane parallel plates about different rotation axes, respectively, it is possible to produce the same action and effect as those in the configuration having the above-described four rotation axes.

Further, for example, in the exposure apparatus in accordance with the present invention, the exposure part may have a configuration to have a light source and a light modulator for modulating the light emitted from the light source on the basis of the exposure data and cause the light beam modulated by the light modulator to be incident on the optical apparatus as the input light. With such a configuration, by exposing the substrate with the modulated light beam, it is possible to partially expose the substrate to thereby form a predetermined pattern on the substrate.

Furthermore, in the exposure method in accordance with the present invention, there may be a case, for example, where a table in which the shift amount, the rotation amount of the shift optical element, and the displacement amount of the correction optical element are associated with one another is created in advance and exposure is performed while the shift amount is adjusted on the basis of the table. With such a configuration, when the necessary shift amount is determined, it is possible to immediately determine the rotation amount of the shift optical element and the displacement amount of the correction optical element which commensurate with the determined shift amount by reference to the table. By performing an exposure operation while applying these amounts, it is possible to obtain an image which is shifted by a desired shift amount.

Although the invention has been described with reference to specific embodiments, this description is not meant to be construed in a limiting sense. Various modifications of the disclosed embodiment, as well as other embodiments of the present invention, will become apparent to persons skilled in the art upon reference to the description of the invention. It is therefore contemplated that the appended claims will cover any such modifications or embodiments as fall within the true scope of the invention.

### [Industrial Applicability]

This invention is available for use to shift positions of a light beam and an image formed by the light beam in a predetermined direction by a predetermined amount. This invention is suitable for technical fields for exposing any one of various substrates such as a semiconductor substrate, a semiconductor package substrate, a printed circuit board, a glass substrate, and the like to form a pattern on the substrate.

### [Reference Signs List]

1, 11-13 image position adjusting apparatus (optical apparatus)
2, 4 exposure apparatus
9 substrate
20, 40 movable stage (substrate holder)
24, 41 exposure head (exposure part)
25, 410 spatial light modulator (light modulator)
111 shift optical element
112, 122, 123, 126, 127, 132, 136 rotary motor (driving part)
113 correction optical element (correction optical element, lens)
114 driving motor (driving part)
115 correction optical element
121, 131 plane parallel plate (shift optical element, correction optical elemen, plane parallel plate)
125, 135 plane parallel plate (shift optical element, correction optical elemen, second plane parallel plate)
201, 401 stage driving mechanism (relative moving part)
Ax0 rotation axis
Ax1 first rotation axis
Ax2 second rotation axis
Ax3 third rotation axis
Ax4 fourth rotation axis
Ax5 fifth rotation axis
Ax6 sixth rotation axis
Ds shift direction
Li input light
Lo output light

## Claims

1. An optical apparatus for shifting an optical path of input light in a shift direction orthogonal to an incident direction thereof and outputting output light along an optical path which is in parallel to and is not the same as the optical path of the input light, comprising:
a shift optical element which is a plane parallel plate having a one-side surface on which the input light is incident and an other-side surface from which the output light is emitted, which are surfaces parallel to each other;
a correction optical element which is arranged on the optical path of the input light or the optical path of the output light and corrects an astigmatic difference appearing in the output light; and
a driving part which rotates the shift optical element to change a shift amount and displaces the correction optical element in conjunction with the shift optical element.

2. The optical apparatus according to claim 1, wherein
a range of rotation of the shift optical element by the driving part includes a case where the one-side surface becomes perpendicular to the incident direction.

3. The optical apparatus according to claim 1 or 2, wherein
the correction optical element is a lens having different powers in a direction along the shift direction and another direction perpendicular to the shift direction, and
the driving part moves the correction optical element in directions to approach and go away from the shift optical element along an optical path.

4. The optical apparatus according to claim 1 or 2, wherein
the correction optical element is a second plane parallel plate different from the shift optical element,
the driving part rotates the shift optical element about a first rotation axis perpendicular to the incident direction of the input light and the shift direction and about a second rotation axis perpendicular to the incident direction and the first rotation axis, respectively, and
the driving part rotates the correction optical element about a third rotation axis in parallel to the first rotation axis and about a fourth rotation axis in parallel to the second rotation axis in conjunction with the shift optical element, respectively.

5. The optical apparatus according to claim 4, wherein
the shift optical element and the correction optical element have the same thickness,
when the driving part rotates the shift optical element about the first rotation axis by a predetermined angle,
the driving part rotates the correction optical element about the third rotation axis by the predetermined angle in the same direction as that to rotate the shift optical element, and
the driving part rotates the shift optical element about the second rotation axis and rotates the correction optical element about the fourth rotation axis by the predetermined angle in reverse directions to each other.

6. The optical apparatus according to claim 1 or 2, wherein
the correction optical element is a second plane parallel plate having the same thickness as that of the shift optical element, and
the driving part rotates the shift optical element about a fifth rotation axis which is perpendicular to the incident direction of the input light and has a tilt of 45 degrees with respect to the shift direction and rotates the correction optical element about a sixth rotation axis perpendicular to the incident direction of the input light and the fifth rotation axis in conjunction with rotation of the shift optical element.

7. An exposure apparatus, comprising:
a substrate holder which holds a substrate;
an exposure part which includes the optical apparatus according to claim 1 and causes the outgoing light output light to be incident on a surface of the substrate, to thereby expose the substrate; and
a relative moving part which relatively moves the exposure part and the substrate holder.

8. The exposure apparatus according to claim 7, wherein
the exposure part includes a light source and a light modulator which modulates light to be emitted from the light source on a basis of exposure data, and causes a light beam modulated by the light modulator to be incident on the optical apparatus as the input light.

9. An exposure method to expose a substrate by causing modulated light to be incident on the substrate, comprising:
interposing an optical apparatus in an optical path of the light, the optical apparatus shifting the light in a predetermined shift direction orthogonal to a traveling direction of the light;
moving the substrate relative to an incident position of the light emitted from the optical apparatus; and
causing the light to be incident on the substrate while adjusting a shift amount of the light by the optical apparatus,
wherein the optical apparatus includes:
a shift optical element which is a plane parallel plate having a one-side surface on which input light is incident and an other-side surface from which the output light is emitted, which are surfaces parallel to each other; and
a correction optical element which is arranged on the optical path of the input light or the optical path of the output light and corrects an astigmatic difference appearing in the output light, and
the optical apparatus rotates the shift optical element and displaces the correction optical element in conjunction with the shift optical element, to thereby adjust the shift amount.

10. The exposure method according to claim 9, wherein
the shift amount is adjusted on the basis of a table associating the shift amount, a rotation amount of the shift optical element, and a displacement amount of the correction optical element.
